(19) **Europäisches Patentamt / European Patent Office / Office européen des brevets**

(11) **EP 3 460 847 B1**

(12) **EUROPEAN PATENT SPECIFICATION**

(45) Date of publication and mention
of the grant of the patent:
**13.05.2020 Bulletin 2020/20**

(51) Int Cl.:
**H01L 27/144** (2006.01)        **H01L 31/0352** (2006.01)
**H01L 31/103** (2006.01)

(21) Application number: **18196362.0**

(22) Date of filing: **24.09.2018**

(54) **ULTRAVIOLET LIGHT RECEIVING ELEMENT AND METHOD OF MANUFACTURING ULTRAVIOLET LIGHT RECEIVING ELEMENT**

ELEMENT ZUR AUFNAHME VON ULTRAVIOLETTEM LICHT UND VERFAHREN ZUR HERSTELLUNG EINES ELEMENTS ZUR AUFNAHME VON ULTRAVIOLETTEM LICHT

ÉLÉMENT DE RÉCEPTION DE LUMIÈRE ULTRAVIOLETTE ET PROCÉDÉ DE FABRICATION D'UN ÉLÉMENT DE RÉCEPTION DE LUMIÈRE ULTRAVIOLETTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.09.2017 JP 2017183963**

(43) Date of publication of application:
**27.03.2019 Bulletin 2019/13**

(73) Proprietor: **ABLIC Inc.**
**Chiba-shi, Chiba (JP)**

(72) Inventors:
• **OKUDA, Kazusa**
**Chiba-shi, Chiba (JP)**
• **FUTATSUGI, Toshiro**
**Chiba-shi, Chiba (JP)**

(74) Representative: **Miller Sturt Kenyon**
**9 John Street**
**London WC1N 2ES (GB)**

(56) References cited:
**CN-U- 205 564 748        US-A1- 2009 179 241**
**US-A1- 2017 207 256**

• **Y. R. SIPAUBA CARVALHO DA SILVA ET AL.: "An Ultraviolet Radiation Sensor Using Differential Spectral Response of Silicon Photodiodes", IEEE SENSORS, 1 November 2015 (2015-11-01), - 4 November 2015 (2015-11-04), pages 1-4, XP032844215, Busan, South Korea DOI: 10.1109/ICSENS.2015.7370656**

**Description**

BACKGROUND OF THE INVENTION

1. Field of the Invention

The present invention relates to an ultraviolet light receiving element and a method of manufacturing an ultraviolet light receiving element.

2. Description of the Related Art

Normally, sunlight irradiating the ground has a wide range wavelength distribution which includes ultraviolet light, visible light, and infrared light in a wavelength range from 300 nm to 2,500 nm. Of the sunlight described above, the ultraviolet light is known to have adverse effects on human body, such as sunburn and skin cancer.

In recent years, high expectations have been put on the development of a sensor capable of detecting the intensity of an ultraviolet light in order to measure effects of the ultraviolet light.

In order to give the light receiving element selective sensitivity to an ultraviolet light alone, there has been proposed an ultraviolet light receiving element which consists of a semiconductor light receiving element having a photodiode sensitive to an ultraviolet light and a photodiode insensitive to an ultraviolet light, and which is configured to calculate a difference between output currents obtained from each of the photodiodes to detect an ultraviolet light (see, for example, WO 2015/151198 A1, US 2009/179241 A1, and Y. R. Sipauba Carvalho da Silva, et al., "An Ultraviolet Radiation Sensor Using Differential Spectral Response of Silicon Photodiodes", 2015 IEEE SENSORS, pp. 1-4).

In this type of ultraviolet light receiving element of the related art, a semiconductor substrate is provided with two photodiodes, in each of which a shallow impurity implantation layer is formed on a surface of the semiconductor substrate in each well implantation layer. The peak concentration position from the surface of the semiconductor substrate is made different between the impurity implantation layers of the two photodiodes, to thereby make one of the two photodiodes sensitive to the ultraviolet light and the other photodiode insensitive to the ultraviolet light.

In the ultraviolet light receiving element of the related art, the peak concentration position from the surface of the semiconductor substrate in the well implantation layer of the photodiode insensitive to the ultraviolet light is set equal to or deeper than the peak concentration position from the surface of the semiconductor substrate in the well implantation layer of the photodiode sensitive to the ultraviolet light.

However, there is no suggestion on how to determine the peak concentration position from the surface of the semiconductor substrate in the well implantation layer of the photodiode insensitive to the ultraviolet light in the ultraviolet light receiving element of the related art and, in some cases, spectral sensitivity in the visible light range increases when the peak concentration position of the photodiode insensitive to the ultraviolet light is simply set deeper than the peak concentration position from the surface of the semiconductor substrate in the well implantation layer of the photodiode sensitive to the ultraviolet light as described above.

SUMMARY OF THE INVENTION

It is therefore an object of the present invention to provide an ultraviolet light receiving element capable of reducing spectral sensitivity in the visible light range and a method of manufacturing the ultraviolet light receiving element.

In one embodiment of the present invention, there is provided an ultraviolet light receiving element including: a first photodiode sensitive to an ultraviolet light provided in a first region of a semiconductor substrate, and including a first well implantation layer of a first conductivity type, a first embedded implantation layer of a second conductivity type, and a first surface implantation layer of the first conductivity type, the first embedded implantation layer being formed in the first well implantation layer, the first surface implantation layer being formed in a surface of the semiconductor substrate in the first embedded implantation layer; and a second photodiode insensitive to an ultraviolet light provided in a second region of the semiconductor substrate, and including a second well implantation layer of the first conductivity type, a second embedded implantation layer of the second conductivity type, and a second surface implantation layer of the first conductivity type, the second embedded implantation layer being formed in the second well implantation layer, the second surface implantation layer being formed in the surface of the semiconductor substrate in the second embedded implantation layer, wherein the second well implantation layer has a peak concentration position deeper than a peak concentration position of the first well implantation layer by a depth equal to a depth from the surface of the semiconductor substrate to a peak concentration position of the second surface implantation layer.

In another embodiment of the present invention, there is provided an ultraviolet light receiving element including: a first photodiode sensitive to the ultraviolet light provided in a first region of a semiconductor substrate, and including a first well implantation layer of a first conductivity type, a first embedded implantation layer of a second conductivity type, and a first surface implantation layer of the first conductivity type, the first embedded implantation layer being formed in the first well implantation layer, the first surface implantation layer being formed in a surface of the semiconductor substrate in the first embedded implantation layer; and a second photodiode insensitive to the ultraviolet light provided in a second region of the semiconductor substrate, and including a second well implantation layer of the first conductivity type, a second embedded implantation layer of the second conductivity type, and a second surface implantation layer of the first conductivity type, the second embedded implantation layer being formed in the second well implantation layer, the second surface implantation layer being formed in the surface of the semiconductor substrate in the second embedded implantation layer, wherein the second well implantation layer has a peak concentration position deeper than the peak concentration position of the first well implantation layer by a depth $d_p$ which is calculated by the following expression:

$$d_p \approx d_s \exp(\alpha x_p)$$

where $d_s$ is a depth from the surface of the semiconductor substrate to a peak concentration position of the second surface implantation layer, $x_p$ is a depth from the surface of the semiconductor substrate to a peak concentration position of the first well implantation layer, $\alpha$ is a light absorption coefficient in the semiconductor substrate, and $\alpha x_p$ is not regarded as zero.

In still another embodiment of the present invention, there is provided a method of manufacturing an ultraviolet light receiving element including: forming, in a first region of a semiconductor substrate of a first conductivity type, a first photodiode sensitive to the ultraviolet light including a first well implantation layer of a second conductivity type, a first embedded implantation layer of the first conductivity type, and a first surface implantation layer of the second conductivity type, the first embedded implantation layer being formed in the first well implantation layer, the first surface implantation layer being formed in a surface of the semiconductor substrate in the first embedded implantation layer; and forming, in a second region of the semiconductor substrate, a second photodiode insensitive to the ultraviolet light including a second well implantation layer of the second conductivity type, a second embedded implantation layer of the first conductivity type, and a second surface implantation layer of the second conductivity type, the second embedded implantation layer being formed in the second well implantation layer, the second surface implantation layer being formed in the surface of the semiconductor substrate in the second embedded implantation layer, wherein the second well implantation layer is formed so as to have a peak concentration position deeper than a peak concentration position of the first well implantation layer by a depth equal to a depth from the surface of the semiconductor substrate to a peak concentration position of the second surface implantation layer.

In still another embodiment of the present invention, there is provided a method of manufacturing an ultraviolet light receiving element including: forming, in a first region of a semiconductor substrate of a first conductivity type, a first photodiode sensitive to an ultraviolet light including a first well implantation layer of a second conductivity type, a first embedded implantation layer of the first conductivity type, and a first surface implantation layer of the second conductivity type, the first embedded implantation layer being formed in the first well implantation layer, the first surface implantation layer being formed in a surface of the semiconductor substrate in the first embedded implantation layer; and forming, in a second region of the semiconductor substrate, a second photodiode insensitive to the ultraviolet light including a second well implantation layer of the second conductivity type, a second embedded implantation layer of the first conductivity type, and a second surface implantation layer of the second conductivity type, the second embedded implantation layer being formed in the second well implantation layer, the second surface implantation layer being formed in the surface of the semiconductor substrate in the second embedded implantation layer, wherein the second well implantation layer is formed so as to have a peak concentration position deeper than the peak concentration position of the first well implantation layer by a depth $d_p$ which is calculated by the following expression:

$$d_p \approx d_s \exp(\alpha x_p)$$

where $d_s$ is a depth from the surface of the semiconductor substrate to a peak concentration position of the second surface implantation layer, $x_p$ is a depth from the surface of the semiconductor substrate to a peak concentration position of the first well implantation layer, $\alpha$ is a light absorption coefficient in the semiconductor substrate, and $\alpha x_p$ is not regarded as zero.

According to above embodiments of the present invention, visible light sensitivities can be substantially equalized in both of the photodiode sensitive to the ultraviolet light and the photodiode insensitive to the ultraviolet light. The ultraviolet light receiving element and the method of manufacturing the ultraviolet light receiving element capable of reducing spectral sensitivity in the visible light range can consequently be provided.

BRIEF DESCRIPTION OF THE DRAWINGS

Embodiments of the invention will now be described, by way of example only, with reference to the accompanying drawings, in which:

FIG. 1 is a sectional view for illustrating the configuration of an ultraviolet light receiving element according to a first embodiment of the present invention;

FIG. 2 is a graph for showing attenuation of the intensity of a light in depth direction when a single-crystal silicon substrate is used as a semiconductor substrate;

FIG. 3 is a sectional view for illustrating a manufacturing step in a method of manufacturing the ultraviolet light receiving element according to the first embodiment of the present invention;

FIG. 4 is a sectional view for illustrating a manufacturing step in the method of manufacturing the ultraviolet light receiving element according to the first embodiment of the present invention;

FIG. 5 is a sectional view for illustrating a manufacturing step in the method of manufacturing the ultraviolet light receiving element according to the first embodiment of the present invention;

FIG. 6 is a graph for showing spectral sensitivity characteristics in the ultraviolet light receiving element according to the first embodiment of the present invention, and spectral sensitivity characteristics observed when peak concentration positions of two well implantation layers are set to the same;

FIG. 7 is a sectional view for illustrating the configuration of an ultraviolet light receiving element according to a second embodiment of the present invention;

FIG. 8 is a sectional view for illustrating a manufacturing step in a method of manufacturing the ultraviolet light receiving element according to the second embodiment of the present invention;

FIG. 9 is a sectional view for illustrating the manufacturing step in a method of manufacturing the ultraviolet light receiving element according to the second embodiment of the present invention; and

FIG. 10 is a graph for showing spectral sensitivity characteristics in the ultraviolet light receiving element according to the second embodiment of the present invention.

DESCRIPTION OF THE EMBODIMENTS

The invention will now be described herein with reference to illustrative embodiments.

[First Embodiment]

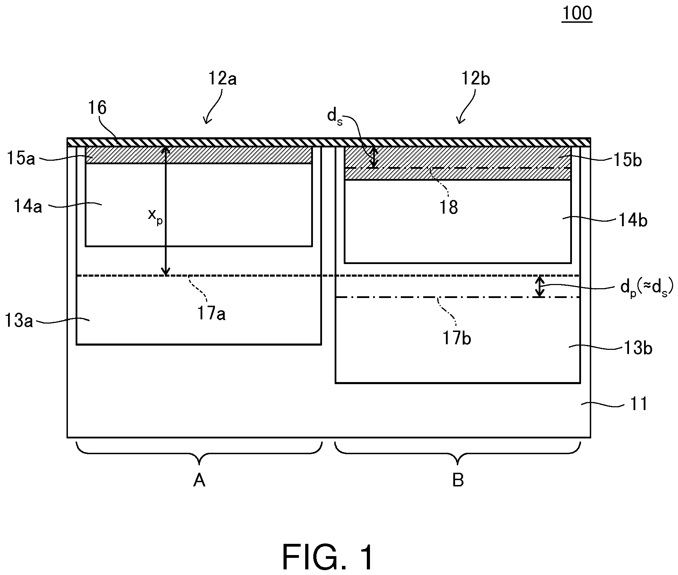

FIG. 1 is a sectional view for illustrating a configuration of an ultraviolet light receiving element 100 according to the first embodiment of the present invention.

The ultraviolet light receiving element 100 according to the first embodiment includes a photodiode 12a which is provided in a region A of an N-type semiconductor substrate 11 and which is sensitive to an ultraviolet light, a photodiode 12b which is provided in a region B of the semiconductor substrate 11 and which is insensitive to the ultraviolet light, and a thermal oxide film 16 which is formed on a surface of the semiconductor substrate 11.

The photodiode 12a includes a P-type (first conductivity-type) well implantation layer 13a, an N-type (second conductivity-type) embedded implantation layer 14a which is formed in the well implantation layer 13a, and a P-type surface implantation layer 15a which is formed in the surface of the semiconductor substrate 11 in the embedded implantation layer 14a. The surface implantation layer 15a has a peak concentration position at the topmost surface. A broken line 17a denotes a peak concentration position of the well implantation layer 13a.

The photodiode 12b includes a P-type well implantation layer 13b, an N-type embedded implantation layer 14b which is formed in the well implantation layer 13b, and a P-type surface implantation layer 15b which is formed in the surface of the semiconductor substrate 11 in the embedded implantation layer 14b. A dashed-dotted line 17b denotes a peak concentration position of the well implantation layer 13b, and a dashed-dotted line 18 denotes a peak concentration position of the surface implantation layer 15b.

In the ultraviolet light receiving element 100 according to the first embodiment, as illustrated in FIG. 1, a depth $d_p$ from the peak concentration position 17a of the well implantation layer 13a to the peak concentration position 17b of the well implantation layer 13b is equal to a depth $d_s$ from the surface of the semiconductor substrate 11 to the peak concentration position 18 of the surface implantation layer 15b.

A description is given below on a method of determining the peak concentration position 17b of the P-type well implantation layer 13b in the photodiode 12b in the ultraviolet light receiving element 100 according to the first embodiment.

The method of determining the peak concentration position 17b in the first embodiment has been obtained by taking notice that spectral characteristics in a photodiode vary depending on the position and depth-wise width of an area in which carriers generated by light absorption can be collected in the crystal of the semiconductor substrate, namely, an area sandwiched between the peak concentration position 18 of the surface implantation layer 15b and the peak concentration position 17b of the well implantation layer 13b.

When a light having an intensity $I_o$ enters a surface of a light receiving element, an intensity $I_s$ of the light at a depth x in a semiconductor substrate that is a constituent of the light receiving element is expressed as the following Expression (1) with the use of an absorption coefficient $\alpha$ which is determined by the type of the crystal used as the semiconductor and the wavelength of the light.

$$I_S \approx I_o \exp(-\alpha x) \; \cdots (1)$$

The amount of light absorbed at the depth x in the crystal is obtained from the Expression (1), and a photocurrent I generated at that point is accordingly expressed as the following Expression (2) with the use of an elementary charge q, a wavelength $\lambda$, a light speed c, and the Planck's constant h.

$$I = \frac{q\lambda}{hc} I_o \alpha \exp(-\alpha x) \; \cdots (2)$$

If the sum of photocurrents generated between the surface of the semiconductor substrate 11 and a certain depth $x_d$ can be taken out as an output current, the output current which is given as $I_{ph}$ can be expressed as the following Expression (3).

$$I_{ph} = \frac{q\lambda}{hc} I_o \{1 - \exp(-\alpha x_d)\} \; \cdots (3)$$

From the above Expressions (1) to (3), suppose that the depth from the surface of the semiconductor substrate 11 to the peak concentration position 17a of the well implantation layer 13a is given as $x_p$, the depth from the surface of the semiconductor substrate 11 to the peak concentration position 18 of the surface implantation layer 15b is given as $d_s$, and the depth from the peak concentration position 17a of the well implantation layer 13a to the peak concentration position 17b of the well implantation layer 13b is given as $d_p$, then an output current $I_{ph-HS}$ of the photodiode 12a and an output current $I_{Ph-LS}$ of the photodiode 12b with respect to a certain wavelength can be expressed as the following Expressions (4) and (5), respectively.

$$I_{ph-HS} = \frac{q\lambda}{hc} I_o \{1 - \exp(-\alpha x_p)\} \; \cdots (4)$$

$$I_{ph-LS} = \frac{q\lambda}{hc} I_o \{\exp(-\alpha d_s) - \exp(-\alpha[x_p + d_p])\} \; \cdots (5)$$

From the Expressions (4) and (5), an output current difference $I_{ph-DIFF}$ between the output currents of the photodiodes 12a and 12b can be expressed as the following Expression (6).

$$I_{ph-DIFF} = \frac{q\lambda}{hc} I_o \{1 - \exp(-\alpha x_p)\} - \frac{q\lambda}{hc} I_o \{\exp(-\alpha d_s) - \exp(-\alpha[x_p + d_p])\} \; \cdots (6)$$

A condition under which the output current difference $I_{ph-DIFF}$ is zero at the wavelength $\lambda$ is required in order to suppress light sensitivity in the visible light range. In other words, a value of $d_p$ that satisfies the following Expression (7) should be obtained.

$$\exp\left(-\alpha d_p\right) = 1 + \exp\left(\alpha x_p\right)\left[\exp\left(-\alpha d_s\right) - 1\right] \quad \cdots (7)$$

In reduction of sensitivity to the visible light included in sunlight, for example, consideration for the most intense light having the wavelength $\lambda$ of longer than 500 nm is required. The absorption coefficient $\alpha$ of the semiconductor with respect to a light longer in wavelength than the ultraviolet light is normally low. In other words, it is regarded that $\alpha dp \ll 1$ and $ad_s \ll 1$ hold in Expression (7). When $\alpha k \ll 1$ holds, $\exp(-\alpha k)$ can be approximated as Expression (8).

$$\exp\left(-\alpha k\right) \approx 1 - \alpha k \quad \cdots (8)$$

Expression (9) can accordingly be obtained from Expression (7) and Expression (8).

$$d_p \approx d_s \exp\left(\alpha x_p\right) \quad \cdots (9)$$

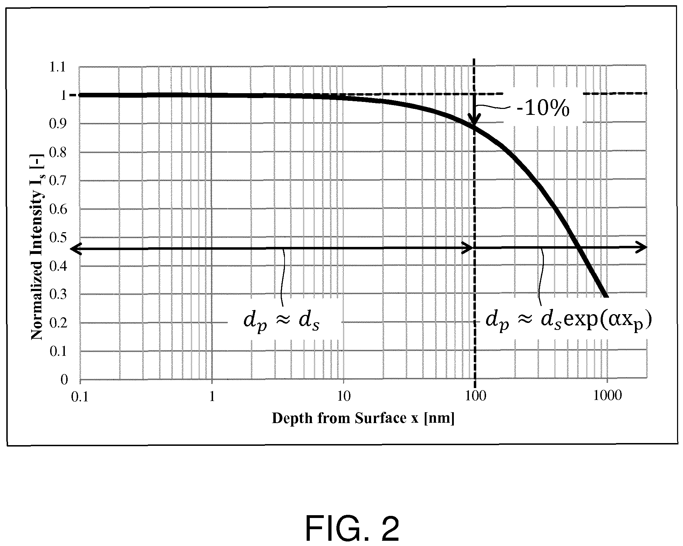

As described above, in reduction of sensitivity to the visible light included in sunlight, consideration for a light having the wavelength $\lambda$ of longer than 500 nm is required. The absorption coefficient $\alpha$ of, for example, a single-crystal silicon substrate used as the semiconductor substrate 11 is 1.11E+06 [1/m] with respect to a light having a wavelength of 500 nm. A relation observed in this case between the depth x in the single-crystal silicon substrate and the intensity $I_s$ of the light is shown in FIG. 2 in the form of graph in accordance with Expression (1).

When single-crystal silicon is used, the light having a wavelength of 500 nm has an absorption coefficient of about 1/100 compared with the ultraviolet light having a shorter wavelength, and, as can be seen in FIG. 2, since the intensity of the light attenuates little in a shallow region of the single-crystal silicon substrate, the intensity of the light having a wavelength of 500 nm does not vary much depending on depth. In a region in which the depth x is less than 100 nm, in particular, the intensity $I_s$ of the light changes only by 10% or so, and it can be regarded that the intensity $I_s$ of the light hardly attenuates in the region.

Accordingly, in FIG. 2, the depth $x_p$ is less than 100 nm in a region where it can be regarded that the intensity $I_s$ of the light hardly attenuates, and $\alpha x_p \ll 1$ holds in the above Expression (9). That is, $\alpha x_p$ can be regarded as zero in the Expression (9). Thus, by forming the ultraviolet light receiving element 100 so as to make $d_p$ and $d_s$ an equal value, the photodiode 12a and the photodiode 12b can be given equal sensitivity in the visible light range. In other words, the difference in output current between the photodiode 12a and the photodiode 12b can be reduced.

As described above, in the ultraviolet light receiving element 100 according to the first embodiment, the depth $d_s$ from the surface of the semiconductor substrate 11 to the peak concentration position 18 of the surface implantation layer 15b and the depth $d_p$ from the peak concentration position 17a of the well implantation layer 13a to the peak concentration position 17b of the well implantation layer 13b are set equal to each other as illustrated in FIG. 1. The ultraviolet light receiving element 100 reduced in spectral sensitivity in the visible light range can thus be obtained.

A method of manufacturing the ultraviolet light receiving element 100 according to the first embodiment is described next.

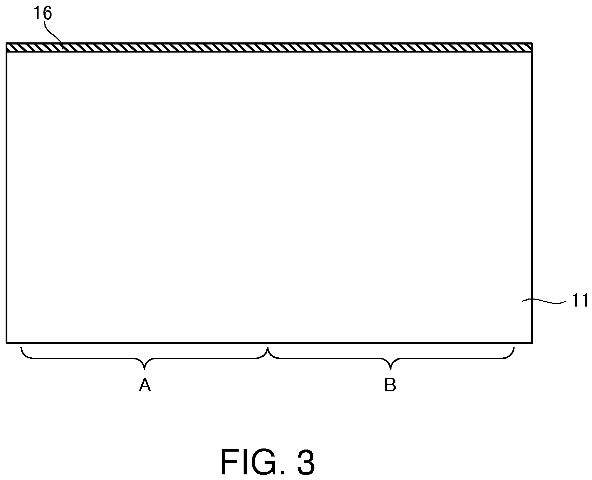

FIG. 3 to FIG. 5 are sectional views for illustrating manufacturing steps in the method of manufacturing the ultraviolet light receiving element 100 according to the first embodiment.

First, as illustrated in FIG. 3, thermal oxidation is performed on the semiconductor substrate 11 to form the thermal oxide film 16 on the surface of the semiconductor substrate 11. A preferred thickness of the thermal oxide film 16 is from approximately 6 nm to approximately 10 nm.

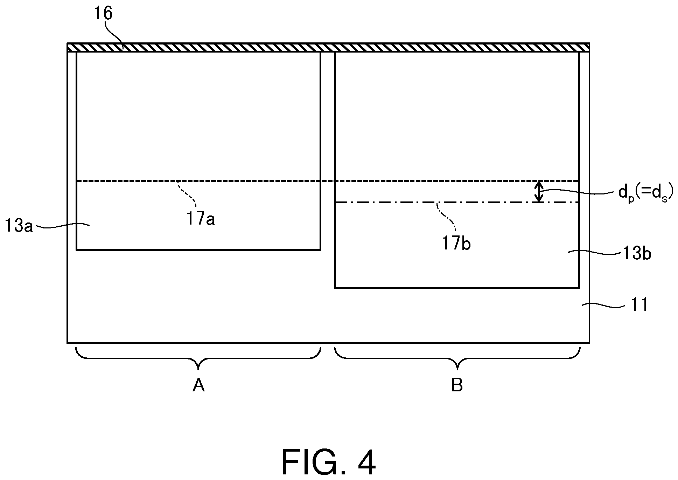

Next, as illustrated in FIG. 4, the well implantation layer 13a and the well implantation layer 13b are formed by performing ion implantation selectively in each of the region A and the region B and implanting $BF_2^+$ as P-type impurities.

In this step, the implantation energy and the implantation impurity dose are set so that the depth $d_p$ from the peak concentration position 17a of the well implantation layer 13a to the peak concentration position 17b of the well implantation layer 13b is equal to a predetermined value of the depth $d_s$ from the surface of the semiconductor substrate 11 to the peak concentration position 18 of the surface implantation layer 15b (see FIG. 1). For instance, the implantation energy for forming the well implantation layer 13a is set to 100 keV, the implantation energy for forming the well implantation layer 13b is set to 120 keV, and the implanted impurity dose is set to 5.0E12 [ions/cm$^2$] for each of the well implantation layers 13a and 13b.

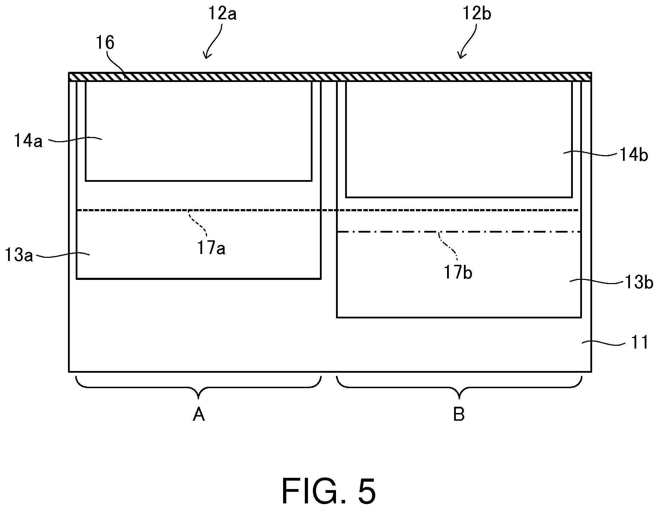

Next, as illustrated in FIG. 5, the embedded implantation layer 14a and the embedded implantation layer 14b are formed by selective ion implantation of $As^+$ in each of the well implantation layer 13a and the well implantation layer 13b as N-type impurities.

In this step, the implantation energy for forming the embedded implantation layer 14a and the implantation energy for forming the embedded implantation layer 14b are both set to, for example, 40 keV, and the implanted impurity dose is set to, for example, 1.0E13 [ions/cm$^2$], for each of the embedded implantation layers 14a and 14b.

The semiconductor substrate 11 is then annealed to electrically activate the implanted impurities. Rapid thermal annealing (RTA) is conducted here at 950°C for 1 second in order to suppress the diffusion of the implanted impurities.

Next, as illustrated in FIG. 1, the surface implantation layer 15a and the surface implantation layer 15b are formed by selective ion implantation of BF$_2^+$ in each of the embedded implantation layer 14a and the embedded implantation layer 14b as P-type impurities. The surface implantation layer 15b is formed so that the depth d$_s$ from the surface of the semiconductor substrate 11 to the peak concentration position 18 of the surface implantation layer 15b is equal to the predetermined depth described above, namely, the depth d$_p$.

The ion implantation energy and the implanted impurity dose in this step are set to, for example, 1 keV and 1.5E14 [ions/cm$^2$], respectively, to form the surface implantation layer 15a, and to 10 keV and 9.0E13 [ions/cm$^2$], respectively, to form the surface implantation layer 15b.

The semiconductor substrate 11 is then subjected to RTA at a high temperature for a short time (e.g., at 1,000°C for 1 second) to electrically activate the impurities in the surface implantation layer 15a and the surface implantation layer 15b.

The ultraviolet light receiving element 100 according to the first embodiment which is illustrated in FIG. 1 is manufactured in the manner described above.

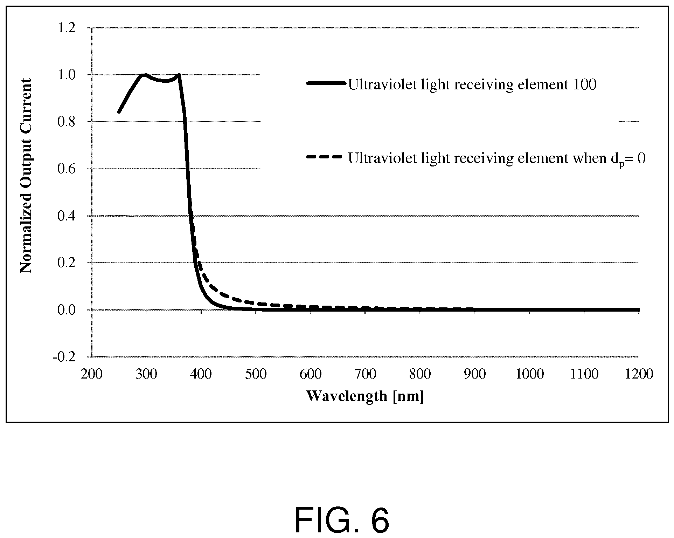

The spectral sensitivity characteristics of the ultraviolet light receiving element 100 which is formed by the manufacturing method described above and the spectral sensitivity characteristics of the ultraviolet light receiving element in which the depth d$_p$ from the peak concentration position 17a of the well implantation layer 13a to the peak concentration position 17b of the well implantation layer 13b is set to zero, that is, in which the peak concentration position 17a of the well implantation layer 13a and the peak concentration position 17b of the well implantation layer 13b are set to the same depth are shown in FIG. 6. As seen in FIG. 6, in the spectral sensitivity characteristics of the ultraviolet light receiving element when d$_p$ is zero, sensitivity remains around a wavelength exceeding 450 nm. In the spectral sensitivity characteristics of the ultraviolet light receiving element 100 formed so as to set d$_p$ and d$_s$ to the same value, on the other hand, sensitivity is substantially zero in a range where a wavelength is 450 nm or longer. The ultraviolet light receiving element 100 according to the first embodiment can thus have spectral sensitivity characteristics that provide sensitivity to the light in the ultraviolet range and that keep visible light sensitivity low.

[Second Embodiment]

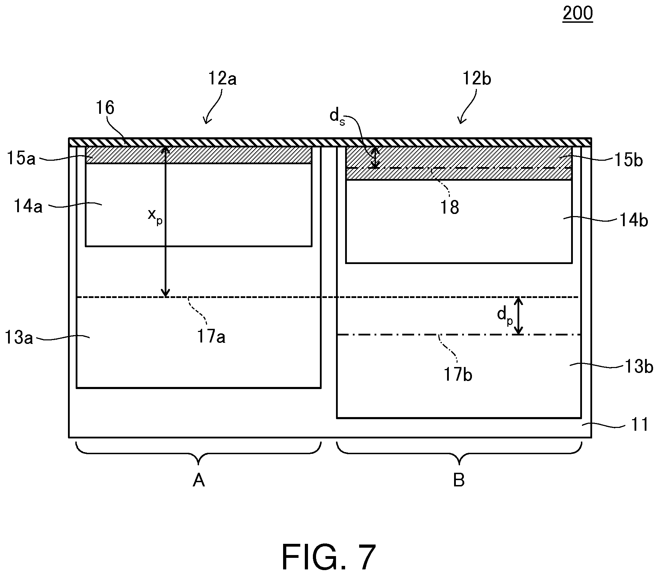

FIG. 7 is a sectional view for illustrating the configuration of an ultraviolet light receiving element 200 according to the second embodiment of the present invention. Components that are the same as those of the ultraviolet light receiving element 100 according to the first embodiment which is illustrated in FIG. 1 are denoted by the same reference numerals, and redundant descriptions are omitted as appropriate.

A main difference between the ultraviolet light receiving element 200 according to the second embodiment and the ultraviolet light receiving element 100 according to the first embodiment is that the depth d$_s$ from the surface of the semiconductor substrate 11 to the peak concentration position 18 of the surface implantation layer 15b and the depth d$_p$ from the peak concentration position 17a of the well implantation layer 13a to the peak concentration position 17b of the well implantation layer 13b differ from each other.

A description is given below on a method of determining the peak concentration position 17b in the P-type well implantation layer 13b of the photodiode 12b in the ultraviolet light receiving element 200 according to the second embodiment.

The method of determining the peak concentration position 17b in the second embodiment has also been obtained in the same manner as in the first embodiment by taking notice that spectral characteristics in a photodiode vary depending on the position and depth-wise width of an area in which carriers generated by light absorption can be collected in the crystal of the semiconductor substrate.

In order to consider a light having the wavelength λ of longer than 500 nm similar to the first embodiment, FIG. 2 is referred to again in which a graph in accordance with the above Expression (1) is shown. FIG. 2 shows the relation observed between the depth x in a single-crystal silicon substrate that is the semiconductor substrate 11 and the intensity I$_s$ of the light, when a single-crystal silicon substrate having the absorption coefficient α of 1.11E+06 [1/m] with respect to a light having a wavelength of 500 nm is used as the semiconductor substrate 11.

As described above, the intensity of the light attenuates little in a shallow region of the single-crystal silicon substrate, and accordingly does not vary much depending on depth. In particular, the intensity I$_s$ of the light in a region in which the depth x is less than 100 nm changes only by 10% or so, and it can be regarded that the intensity I$_s$ of the light is substantially constant in the region.

When the depth x exceeds 100 nm, on the other hand, the light having a wavelength of 500 nm attenuates in intensity to 90% or less of the incident light. From then on, the intensity of the light attenuates more as the depth increases.

Accordingly, because in the region in FIG. 2 where the intensity $I_s$ of the light attenuates considerably, the depth $X_p$ exceeds 100 nm, inequality $\alpha X_p \ll 1$ does not hold in the above Expression (9), that is, $\alpha x_p$ cannot be regarded as zero in the Expression (9).

For that reason, the ultraviolet light receiving element 200 according to the second embodiment is formed with the use of $d_p$ that can be obtained from the above Expression (9). In this manner, the photodiode 12a and the photodiode 12b can be given equal sensitivity in the visible light range. In other words, the difference in output current between the photodiode 12a and the photodiode 12b can be reduced in the visible light range.

In the second embodiment, the depth $d_p$ from the peak concentration position 17a of the well implantation layer 13a to the peak concentration position 17b of the well implantation layer 13b is determined in a manner described below, for example.

To give a specific example, suppose that the depth $d_s$ from the surface of the semiconductor substrate 11 to the peak concentration position 18 of the surface implantation layer 15b is 50 nm, the depth $X_p$ from the surface of the semiconductor substrate 11 to the peak concentration position 17a of the well implantation layer 13a is 400 nm, and that a single-crystal silicon substrate having the absorption coefficient $\alpha$ of 1.11E+06 [1/m] with respect to a light having a wavelength of 500 nm is used as the semiconductor substrate 11, the depth $d_p$ is then calculated as 78 nm by the above Expression (9). In this case, the ultraviolet light receiving element 200 reduced in spectral sensitivity in the visible light range can accordingly be obtained by setting the depth $d_p$ equal to 78 nm from the peak concentration position 17a of the well implantation layer 13a to the peak concentration position 17b of the well implantation layer 13b.

A method of manufacturing the ultraviolet light receiving element 200 according to the second embodiment is described next.

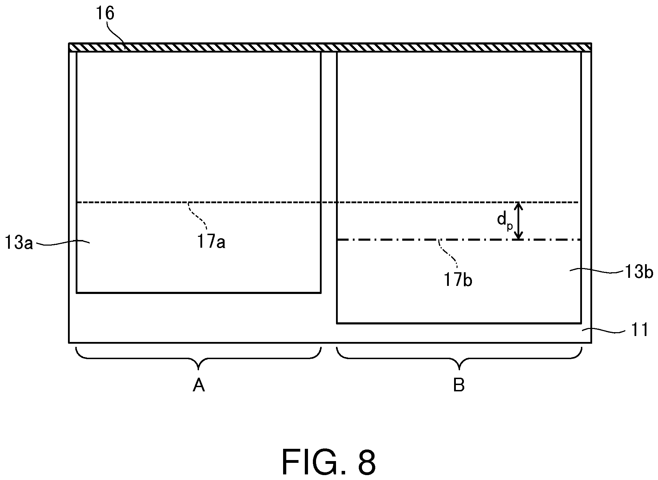

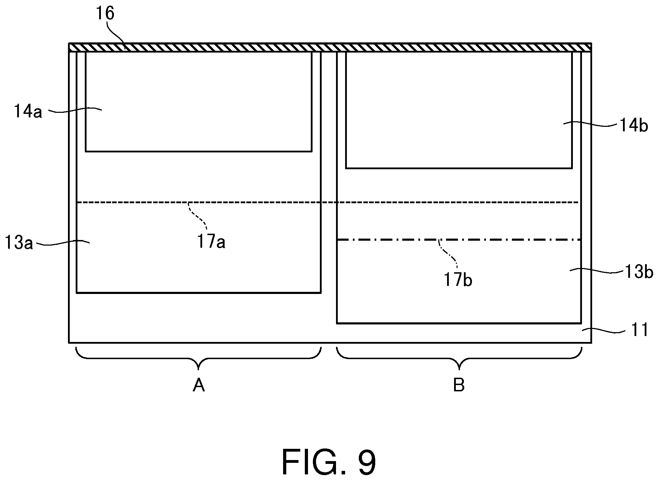

FIG. 8 and FIG. 9 are sectional views for illustrating manufacturing steps in the method of manufacturing the ultraviolet light receiving element 200 according to the second embodiment. The following description is about the method of manufacturing the ultraviolet light receiving element 200 of the specific example given above, in which a single-crystal silicon substrate having the absorption coefficient $\alpha$ of 1.11E+06 [1/m] with respect to the light having a wavelength of 500 nm is used as the semiconductor substrate 11, the depth $d_s$ from the surface of the semiconductor substrate 11 to the peak concentration position 18 of the surface implantation layer 15b is 50 nm, the depth $X_p$ from the surface of the semiconductor substrate 11 to the peak concentration position 17a of the well implantation layer 13a is 400 nm, and the depth $d_p$ from the peak concentration position 17a of the well implantation layer 13a to the peak concentration position 17b of the well implantation layer 13b is 78 nm.

First, as illustrated in FIG. 3, thermal oxidation is performed on the semiconductor substrate 11 to form the thermal oxide film 16 on the surface of the semiconductor substrate 11, similar to the method of manufacturing the ultraviolet light receiving element 100 according to the first embodiment. A preferred thickness of the thermal oxide film 16 is from approximately 6 nm to approximately 10 nm.

Next, as illustrated in FIG. 8, the well implantation layer 13a and the well implantation layer 13b are formed by performing ion implantation selectively in each of the region A and the region B and implanting $B^+$ as P-type impurities.

The implantation energy and the implanted impurity dose in this step are set so that the depth $d_p$ from the peak concentration position 17a of the well implantation layer 13a to the peak concentration position 17b of the well implantation layer 13b is a depth calculated by the above Expression (9), in this example, 78 nm. In this example, the implantation energy for forming the well implantation layer 13a is set to 110 keV, the implantation energy for forming the well implantation layer 13b is set to 120 keV, and the implanted impurity dose is set to 5.0E12 [ions/cm$^2$] for each of the well implantation layers 13a and 13b.

Next, as illustrated in FIG. 9, the embedded implantation layer 14a and the embedded implantation layer 14b are formed by selectively implanting $P^+$ as N-type impurities in each of the well implantation layer 13a and the well implantation layer 13b through ion implantation.

In this example, the implantation energy for forming the embedded implantation layer 14a is set to 36 keV, the implantation energy for forming the embedded implantation layer 14b is set to 120 keV, and the implanted impurity dose is set to 9.0E12 [ions/cm$^2$] for each of the embedded implantation layers 14a and 14b.

The semiconductor substrate 11 is then annealed to electrically activate the implanted impurities. RTA is conducted here at 950°C for 5 seconds in order to suppress the diffusion of the implanted impurities.

Next, as illustrated in FIG. 7, the surface implantation layer 15a and the surface implantation layer 15b are formed by selectively implanting $BF_2^+$ as P-type impurities in each of the embedded implantation layer 14a and the embedded implantation layer 14b through ion implantation. In this example, the surface implantation layer 15b is formed so that the depth $d_s$ from the surface of the semiconductor substrate 11 to the peak concentration position 18 of the surface implantation layer 15b is 50 nm.

The ion implantation energy and the implanted impurity dose in this example are set to 8 keV and 5.0E13 [ions/cm$^2$], respectively, to form the surface implantation layer 15a, and to 35 keV and 4.5E13 [ions/cm$^2$], respectively,

to form the surface implantation layer 15b.

The semiconductor substrate 11 is then subjected to RTA at a high temperature for a short time (e.g., at 1,000°C for 1 second) to electrically activate the impurities in the surface implantation layer 15a and the surface implantation layer 15b.

The ultraviolet light receiving element 200 according to the second embodiment which is illustrated in FIG. 7 is manufactured in the manner described above.

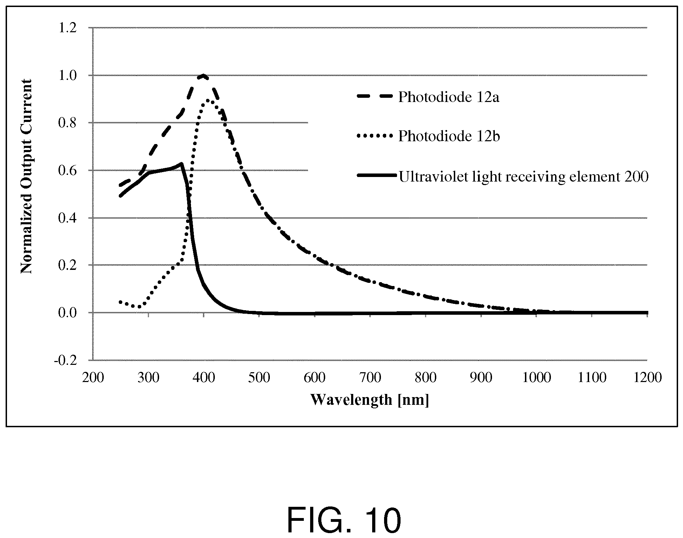

FIG. 10 is a graph for showing the spectral sensitivity characteristics of the ultraviolet light receiving element 200 that is obtained by the method of manufacturing the ultraviolet light receiving element 200 described as a specific example of the second embodiment. It is understood from FIG. 10 that the output current of the photodiode 12a and the output current of the photodiode 12b become a substantial match to each other in a range where a wavelength of approximately 450 nm or higher. The ultraviolet light receiving element 200 according to the second embodiment can thus have spectral sensitivity characteristics that provide sensitivity to a light in the ultraviolet range and that keep visible light sensitivity low by calculating the difference between the output currents of the photodiode 12a and the photodiode 12b.

It is apparent that the present invention is not limited to the above embodiments, but may be modified and changed without departing from the scope of the invention.

For instance, a shallow region near a surface of the surface implantation layer 15b of the photodiode 12b which is insensitive to the ultraviolet light in the embodiments described above may be provided with a surface implantation layer having a conductivity type opposite to the conductivity type of the surface implantation layer 15b to effectively nullify a current generated by the ultraviolet light, as described in Y. R. Sipauba Carvalho da Silva, et al., "An Ultraviolet Radiation Sensor Using Differential Spectral Response of Silicon Photodiodes", 2015 IEEE SENSORS, pp. 1-4.

While an example in which a single crystal silicon substrate is used as a semiconductor substrate has been described in the embodiments described above, the present invention is not limited to this, and other semiconductor substrates such as a GaAs substrate can also be used, for example.

While the first conductivity type is the P type and the second conductivity type is the N type in the embodiments described above, the conductivity types may be switched so that the first conductivity type is the N type and the second conductivity type is the P type.

## Claims

1. An ultraviolet light receiving element (100), comprising:

   a first photodiode (12a) sensitive to an ultraviolet light provided in a first region (A) of a semiconductor substrate (11), and including a first well implantation layer (13a) of a first conductivity type, a first embedded implantation layer (14a) of a second conductivity type, and a first surface implantation layer (15a) of the first conductivity type, the first embedded implantation layer being formed in the first well implantation layer, the first surface implantation layer being formed in a surface of the semiconductor substrate in the first embedded implantation layer; and

   a second photodiode (12b) insensitive to an ultraviolet light provided in a second region (B) of the semiconductor substrate, and including a second well implantation layer (13b) of the first conductivity type, a second embedded implantation layer (14b) of the second conductivity type, and a second surface implantation layer (15b) of the first conductivity type, the second embedded implantation layer being formed in the second well implantation layer, the second surface implantation layer being formed in the surface of the semiconductor substrate in the second embedded implantation layer,
   **characterised in that**
   the second well implantation layer (13b) has a peak concentration position (17b) deeper than a peak concentration position (17a) of the first well implantation layer by a depth ($d_p$) equal to a depth ($d_s$) from the surface of the semiconductor substrate to a peak concentration position (18) of the second surface implantation layer.

2. An ultraviolet light receiving element (200), comprising:

   a first photodiode (12a) sensitive to the ultraviolet light provided in a first region (A) of a semiconductor substrate (11), and including a first well implantation layer (13a) of a first conductivity type, a first embedded implantation layer (14a) of a second conductivity type, and a first surface implantation layer (15a) of the first conductivity type, the first embedded implantation layer being formed in the first well implantation layer, the first surface implantation layer being formed in a surface of the semiconductor substrate in the first embedded implantation layer; and

a second photodiode (12b) insensitive to the ultraviolet light provided in a second region (B) of the semiconductor substrate, and including a second well implantation layer (13b) of the first conductivity type, a second embedded implantation layer (14b) of the second conductivity type, and a second surface implantation layer (15b) of the first conductivity type, the second embedded implantation layer being formed in the second well implantation layer, the second surface implantation layer being formed in the surface of the semiconductor substrate in the second embedded implantation layer,

**characterised in that**

the second well implantation layer (13b) has a peak concentration position deeper (17b) than the peak concentration position (17a) of the first well implantation layer by a depth $d_p$ which is calculated by the following expression:

$$d_p \approx d_s \exp(\alpha x_p)$$

where $d_s$ is a depth from the surface of the semiconductor substrate to a peak concentration position (18) of the second surface implantation layer, $x_p$ is a depth from the surface of the semiconductor substrate to the peak concentration position (17a) of the first well implantation layer, $\alpha$ is a light absorption coefficient in the semiconductor substrate, and $\alpha x_p$ is not regarded as zero.

3.  A method of manufacturing an ultraviolet light receiving element (100), comprising:

forming, in a first region (A) of a semiconductor substrate (11) of a first conductivity type, a first photodiode (12a) sensitive to the ultraviolet light including a first well implantation layer (13a) of a second conductivity type, a first embedded implantation layer (14a) of the first conductivity type, and a first surface implantation layer (15a) of the second conductivity type, the first embedded implantation layer being formed in the first well implantation layer, the first surface implantation layer being formed in a surface of the semiconductor substrate in the first embedded implantation layer; and

forming, in a second region (B) of the semiconductor substrate (11), a second photodiode (12b) insensitive to the ultraviolet light including a second well implantation layer (13b) of the second conductivity type, a second embedded implantation layer (14b) of the first conductivity type, and a second surface implantation layer (15b) of the second conductivity type, the second embedded implantation layer being formed in the second well implantation layer, the second surface implantation layer being formed in the surface of the semiconductor substrate in the second embedded implantation layer,

**characterised in that**

the second well implantation layer is formed so as to have a peak concentration position (17b) deeper than a peak concentration position (17a) of the first well implantation layer by a depth ($d_p$) equal to a depth ($d_s$) from the surface of the semiconductor substrate to a peak concentration position (18) of the second surface implantation layer.

4.  A method of manufacturing an ultraviolet light receiving element (200), comprising:

forming, in a first region (A) of a semiconductor substrate (11) of a first conductivity type, a first photodiode (12a) sensitive to an ultraviolet light including a first well implantation layer (13a) of a second conductivity type, a first embedded implantation layer (14a) of the first conductivity type, and a first surface implantation layer (15a) of the second conductivity type, the first embedded implantation layer being formed in the first well implantation layer, the first surface implantation layer being formed in a surface of the semiconductor substrate in the first embedded implantation layer; and

forming, in a second region (B) of the semiconductor substrate (11), a second photodiode (12b) insensitive to the ultraviolet light including a second well implantation layer (13b) of the second conductivity type, a second embedded implantation layer (14b) of the first conductivity type, and a second surface implantation layer (15b) of the second conductivity type, the second embedded implantation layer being formed in the second well implantation layer, the second surface implantation layer being formed in the surface of the semiconductor substrate in the second embedded implantation layer,

**characterised in that**

the second well implantation layer is formed so as to have a peak concentration position (17b) deeper than the peak concentration position (17a) of the first well implantation layer by a depth $d_p$ which is calculated by the following expression:

$$d_p \approx d_s \exp(\alpha x_p)$$

where $d_s$ is a depth from the surface of the semiconductor substrate to a peak concentration position (18) of the second surface implantation layer, $x_p$ is a depth from the surface of the semiconductor substrate to the peak concentration position (17a) of the first well implantation layer, $\alpha$ is a light absorption coefficient in the semiconductor substrate, and $\alpha x_p$ is not regarded as zero.

**Patentansprüche**

1. Element (100) zur Aufnahme von ultraviolettem Licht, umfassend:

eine erste Fotodiode (12a), die gegenüber einem ultravioletten Licht empfindlich ist, das in einem ersten Bereich (A) eines Halbleitersubstrats (11) bereitgestellt wird, und die eine erste Well-Implantationsschicht (13a) eines ersten Leitfähigkeitstyps, eine erste eingebettete Implantationsschicht (14a) eines zweiten Leitfähigkeitstyps und eine erste Oberflächenimplantationsschicht (15a) des ersten Leitfähigkeitstyps aufweist, wobei die erste eingebettete Implantationsschicht in der ersten Well-Implantationsschicht gebildet wird, wobei die erste Oberflächenimplantationsschicht in einer Oberfläche des Halbleitersubstrats in der ersten eingebetteten Implantationsschicht gebildet wird; und
eine zweite Fotodiode (12b), die gegenüber einem ultravioletten Licht unempfindlich ist, das in einem zweiten Bereich (B) des Halbleitersubstrats bereitgestellt wird, und die eine zweite Wannenimplantationsschicht (13b) des ersten Leitfähigkeitstyps, eine zweite eingebettete Implantationsschicht (14b) des zweiten Leitfähigkeitstyps und eine zweite Oberflächenimplantationsschicht (15b) des ersten Leitfähigkeitstyps aufweist, wobei die zweite eingebettete Implantationsschicht in der zweiten Wannenimplantationsschicht gebildet wird, wobei die zweite Oberflächenimplantationsschicht in der Oberfläche des Halbleitersubstrats in der zweiten eingebetteten Implantationsschicht gebildet wird,
**dadurch gekennzeichnet, dass**
die zweite Wannenimplantationsschicht (13b) eine Spitzenkonzentrationsposition (17b) aufweist, die um eine Tiefe ($d_p$), die gleich einer Tiefe ($d_s$) von der Oberfläche des Halbleitersubstrats zu einer Spitzenkonzentrationsposition (18) der zweiten Oberflächenimplantationsschicht ist, tiefer als eine Spitzenkonzentrationsposition (17a) der ersten Wannenimplantationsschicht ist.

2. Element (200) zur Aufnahme von ultraviolettem Licht, umfassend:

eine erste Fotodiode (12a), die gegenüber dem ultravioletten Licht empfindlich ist, das in einem ersten Bereich (A) eines Halbleitersubstrats (11) bereitgestellt wird, und die eine erste Wannenimplantationsschicht (13a) eines ersten Leitfähigkeitstyps, eine erste eingebettete Implantationsschicht (14a) eines zweiten Leitfähigkeitstyps und eine erste Oberflächenimplantationsschicht (15a) des ersten Leitfähigkeitstyps aufweist, wobei die erste eingebettete Implantationsschicht in der ersten Wannenimplantationsschicht gebildet wird, wobei die erste Oberflächenimplantationsschicht in einer Oberfläche des Halbleitersubstrats in der ersten eingebetteten Implantationsschicht gebildet wird; und
eine zweite Fotodiode (12b), die gegenüber dem ultravioletten Licht unempfindlich ist, das in einem zweiten Bereich (B) des Halbleitersubstrats bereitgestellt wird, und die eine zweite Wannenimplantationsschicht (13b) des ersten Leitfähigkeitstyps, eine zweite eingebettete Implantationsschicht (14b) des zweiten Leitfähigkeitstyps und eine zweite Oberflächenimplantationsschicht (15b) des ersten Leitfähigkeitstyps aufweist, wobei die zweite eingebettete Implantationsschicht in der zweiten Wannenimplantationsschicht gebildet wird, wobei die zweite Oberflächenimplantationsschicht in der Oberfläche des Halbleitersubstrats in der zweiten eingebetteten Implantationsschicht gebildet wird,
**dadurch gekennzeichnet, dass** die zweite Wannenimplantationsschicht (13b) eine tiefere Spitzenkonzentrationsposition (17b) als die Spitzenkonzentrationsposition (17a) der ersten Wannenimplantationsschicht aufweist, und zwar um eine Tiefe $d_p$, die durch den folgenden Ausdruck berechnet wird:

$$d_p \approx d_s \exp(\alpha x_p)$$

wobei $d_s$ eine Tiefe von der Oberfläche des Halbleitersubstrats bis zu einer Spitzenkonzentrationsposition (18) der zweiten Oberflächenimplantationsschicht ist, $x_p$ eine Tiefe von der Oberfläche des Halbleitersubstrats bis zur Spitzenkonzentrationsposition (17a) der ersten Wannenimplantationsschicht ist, $\alpha$ ein Lichtabsorptionskoeffizient im Halbleitersubstrat ist und $\alpha x_p$ nicht als Null angesehen wird.

3.  Verfahren zum Herstellen eines Elements (100) zur Aufnahme von ultraviolettem Licht, umfassend:

Bilden, in einem ersten Bereich (A) eines Halbleitersubstrats (11) eines ersten Leitfähigkeitstyps, einer ersten Fotodiode (12a), die gegenüber dem ultravioletten Licht empfindlich ist und die eine erste Wannenimplantationsschicht (13a) eines zweiten Leitfähigkeitstyps, eine erste eingebettete Implantationsschicht (14a) des ersten Leitfähigkeitstyps und eine erste Oberflächenimplantationsschicht (15a) des zweiten Leitfähigkeitstyps aufweist, wobei die erste eingebettete Implantationsschicht in der ersten Wannenimplantationsschicht gebildet wird, wobei die erste Oberflächenimplantationsschicht in einer Oberfläche des Halbleitersubstrats in der ersten eingebetteten Implantationsschicht gebildet wird; und

Bilden, in einem ersten zweiten (B) des Halbleitersubstrats (11) einer zweiten Fotodiode (12b), die gegenüber dem ultravioletten Licht unempfindlich ist und die eine zweite Wannenimplantationsschicht (13b) des zweiten Leitfähigkeitstyps, eine zweite eingebettete Implantationsschicht (14b) des ersten Leitfähigkeitstyps und eine zweite Oberflächenimplantationsschicht (15b) des zweiten Leitfähigkeitstyps aufweist, wobei die zweite eingebettete Implantationsschicht in der zweiten Wannenimplantationsschicht gebildet wird, wobei die zweite Oberflächenimplantationsschicht in der Oberfläche des Halbleitersubstrats in der zweiten eingebetteten Implantationsschicht gebildet wird,

**dadurch gekennzeichnet,**

**dass** die zweite Wannenimplantationsschicht derart gebildet wird, dass sie eine Spitzenkonzentrationsposition (17b) aufweist, die um eine Tiefe ($d_p$), die gleich einer Tiefe ($d_s$) von der Oberfläche des Halbleitersubstrats zu einer Spitzenkonzentrationsposition (18) der zweiten Oberflächenimplantationsschicht ist, tiefer als eine Spitzenkonzentrationsposition (17a) der ersten Wannenimplantationsschicht ist.

4.  Verfahren zum Herstellen eines Elements (200) zur Aufnahme von ultraviolettem Licht, umfassend:

Bilden, in einem ersten Bereich (A) eines Halbleitersubstrats (11) eines ersten Leitfähigkeitstyps, einer ersten Fotodiode (12a), die gegenüber dem ultravioletten Licht empfindlich ist und die eine erste Wannenimplantationsschicht (13a) eines zweiten Leitfähigkeitstyps, eine erste eingebettete Implantationsschicht (14a) des ersten Leitfähigkeitstyps und eine erste Oberflächenimplantationsschicht (15a) des zweiten Leitfähigkeitstyps aufweist, wobei die erste eingebettete Implantationsschicht in der ersten Wannenimplantationsschicht gebildet wird, wobei die erste Oberflächenimplantationsschicht in einer Oberfläche des Halbleitersubstrats in der ersten eingebetteten Implantationsschicht gebildet wird; und

Bilden, in einem ersten zweiten (B) des Halbleitersubstrats (11) einer zweiten Fotodiode (12b), die gegenüber dem ultravioletten Licht unempfindlich ist und die eine zweite Wannenimplantationsschicht (13b) des zweiten Leitfähigkeitstyps, eine zweite eingebettete Implantationsschicht (14b) des ersten Leitfähigkeitstyps und eine zweite Oberflächenimplantationsschicht (15b) des zweiten Leitfähigkeitstyps aufweist, wobei die zweite eingebettete Implantationsschicht in der zweiten Wannenimplantationsschicht gebildet wird, wobei die zweite Oberflächenimplantationsschicht in der Oberfläche des Halbleitersubstrats in der zweiten eingebetteten Implantationsschicht gebildet wird,

**dadurch gekennzeichnet, dass**

die zweite Wannenimplantationsschicht derart gebildet wird, dass sie eine tiefere Spitzenkonzentrationsposition (17b) als die Spitzenkonzentrationsposition (17a) der ersten Wannenimplantationsschicht aufweist, und zwar um eine Tiefe $d_p$, die durch den folgenden Ausdruck berechnet wird:

$$d_p \approx d_s \exp(\alpha x_p)$$

wobei $d_s$ eine Tiefe von der Oberfläche des Halbleitersubstrats bis zu einer Spitzenkonzentrationsposition (18) der zweiten Oberflächenimplantationsschicht ist, $x_p$ eine Tiefe von der Oberfläche des Halbleitersubstrats bis zur Spitzenkonzentrationsposition (17a) der ersten Wannenimplantationsschicht ist, $\alpha$ ein Lichtabsorptionskoeffizient im Halbleitersubstrat ist und $\alpha x_p$ nicht als Null angesehen wird.

**Revendications**

1. Élément de réception de lumière ultraviolette (100), comprenant :

une première photodiode (12a) sensible à une lumière ultraviolette prévue dans une première région (A) d'un substrat de semi-conducteur (11) et incluant une première couche d'implantation à trou (13a) d'un premier type de conductivité, une première couche d'implantation enchâssée (14a) d'un second type de conductivité et une première couche d'implantation de surface (15a) du premier type de conductivité, la première couche d'implantation enchâssée étant formée dans la première couche d'implantation à trou, la première couche d'implantation de surface étant formée dans une surface du substrat de semi-conducteur dans la première couche d'implantation enchâssée ; et

une seconde photodiode (12b) insensible à une lumière ultraviolette prévue dans une seconde région (B) du substrat de semi-conducteur et incluant une seconde couche d'implantation à trou (13b) du premier type de conductivité, une seconde couche d'implantation enchâssée (14b) du second type de conductivité et une seconde couche d'implantation de surface (15b) du premier type de conductivité, la seconde couche d'implantation enchâssée étant formée dans la seconde couche d'implantation à trou, la seconde couche d'implantation de surface étant formée dans la surface du substrat de semi-conducteur dans la seconde couche d'implantation enchâssée,

**caractérisé en ce que**

la seconde couche d'implantation à trou (13b) a une position de concentration de pointe (17b) plus profonde qu'une position de concentration de pointe (17a) de la première couche d'implantation à trou d'une profondeur ($d_p$) égale à une profondeur ($d_s$) de la surface du substrat de semi-conducteur vers une position de concentration de pointe (18) de la seconde couche d'implantation de surface.

2. Élément de réception de lumière ultraviolette (200), comprenant :

une première photodiode (12a) sensible à la lumière ultraviolette prévue dans une première région (A) d'un substrat de semi-conducteur (11) et incluant une première couche d'implantation à trou (13a) d'un premier type de conductivité, une première couche d'implantation enchâssée (14a) d'un second type de conductivité et une première couche d'implantation de surface (15a) du premier type de conductivité, la première couche d'implantation enchâssée étant formée dans la première couche d'implantation à trou, la première couche d'implantation de surface étant formée dans une surface du substrat de semi-conducteur dans la première couche d'implantation enchâssée ; et

une seconde photodiode (12b) insensible à la lumière ultraviolette prévue dans une seconde région (B) du substrat de semi-conducteur et incluant une seconde couche d'implantation à trou (13b) du premier type de conductivité, une seconde couche d'implantation enchâssée (14b) du second type de conductivité et une seconde couche d'implantation de surface (15b) du premier type de conductivité, la seconde couche d'implantation enchâssée étant formée dans la seconde couche d'implantation à trou, la seconde couche d'implantation de surface étant formée dans la surface du substrat de semi-conducteur dans la seconde couche d'implantation enchâssée,

**caractérisé en ce que**

la seconde couche d'implantation à trou (13b) a une position de concentration de pointe (17b) plus profonde que la position de concentration de pointe (17a) de la première couche d'implantation à trou d'une profondeur ($d_p$) qui est calculée par l'expression suivante :

où $d_s$ est une profondeur de la surface du substrat de semi-conducteur vers une position de concentration de pointe (18) de la seconde couche d'implantation de surface, $x_p$ est une profondeur de la surface du substrat de semi-conducteur vers la position de concentration de pointe (17a) de la première couche d'implantation à trou, $\alpha$ est un coefficient d'absorption de lumière dans le substrat de semi-conducteur, et $\alpha x_p$ n'est pas considéré comme zéro.

3. Procédé de fabrication d'un élément de réception de lumière ultraviolette (100), comprenant :

de former, dans une première région (A) d'un substrat de semi-conducteur (11) d'un premier type de conductivité, une première photodiode (12a) sensible à la lumière ultraviolette incluant une première couche d'implantation à trou (13a) d'un second type de conductivité, une première couche d'implantation enchâssée (14a) du premier type de conductivité et une première couche d'implantation de surface (15a) du second type de conductivité, la première couche d'implantation enchâssée étant formée dans la première couche d'implantation à trou, la première couche d'implantation de surface étant formée dans une surface du substrat de semi-conducteur dans la première couche d'implantation enchâssée ; et

de former, dans une seconde région (B) du substrat de semi-conducteur (11), une seconde photodiode (12b) insensible à la lumière ultraviolette incluant une seconde couche d'implantation à trou (13b) du second type de conductivité, une seconde couche d'implantation enchâssée (14b) du premier type de conductivité et une seconde couche d'implantation de surface (15b) du second type de conductivité, la seconde couche d'implantation enchâssée étant formée dans la seconde couche d'implantation à trou, la seconde couche d'implantation de surface étant formée dans la surface du substrat de semi-conducteur dans la seconde couche d'implantation enchâssée,

**caractérisé en ce que**

la seconde couche d'implantation à trou est formée de manière à avoir une position de concentration de pointe (17b) plus profonde qu'une position de concentration de pointe (17a) de la première couche d'implantation à trou d'une profondeur ($d_p$) égale à une profondeur ($d_s$) de la surface du substrat de semi-conducteur vers une position de concentration de pointe (18) de la seconde couche d'implantation de surface.

4. Procédé de fabrication d'un élément de réception de lumière ultraviolette (200), comprenant :

de former, dans une première région (A) d'un substrat de semi-conducteur (11) d'un premier type de conductivité, une première photodiode (12a) sensible à la lumière ultraviolette incluant une première couche d'implantation à trou (13a) d'un second type de conductivité, une première couche d'implantation enchâssée (14a) du premier type de conductivité et une première couche d'implantation de surface (15a) du second type de conductivité, la première couche d'implantation enchâssée étant formée dans la première couche d'implantation à trou, la première couche d'implantation de surface étant formée dans une surface du substrat de semi-conducteur dans la première couche d'implantation enchâssée ; et

de former, dans une seconde région (B) du substrat de semi-conducteur (11), une seconde photodiode (12b) insensible à la lumière ultraviolette incluant une seconde couche d'implantation à trou (13b) du second type de conductivité, une seconde couche d'implantation enchâssée (14b) du premier type de conductivité et une seconde couche d'implantation de surface (15b) du second type de conductivité, la seconde couche d'implantation enchâssée étant formée dans la seconde couche d'implantation à trou, la seconde couche d'implantation de surface étant formée dans la surface du substrat de semi-conducteur dans la seconde couche d'implantation enchâssée,

**caractérisé en ce que**

la seconde couche d'implantation à trou est formée de manière à avoir une position de concentration de pointe (17b) plus profonde que la position de concentration de pointe (17a) de la première couche d'implantation à trou d'une profondeur ($d_p$) qui est calculée par l'expression suivante :

où $d_s$ est la profondeur de la surface du substrat de semi-conducteur vers une position de concentration de pointe (18) de la seconde couche d'implantation de surface, $x_p$ est une profondeur de la surface du substrat de semi-conducteur vers la position de concentration de pointe (17a) de la première couche d'implantation à trou, $\alpha$ est un coefficient d'absorption de lumière dans le substrat de semi-conducteur, et $\alpha x_p$ n'est pas considéré comme zéro.

FIG. 1

FIG. 2

FIG. 3

FIG. 4

FIG. 5

FIG. 6

200

16

12a

12b

$d_s$

15a

$x_p$

14a

18

15b

14b

17a

$d_p$

13a

17b

13b

11

A

B

# FIG. 7

FIG. 8

FIG. 9

FIG. 10

**EP 3 460 847 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015151198 A1

- US 2009179241 A1

**Non-patent literature cited in the description**

- **Y. R. SIPAUBA CARVALHO DA SILVA et al.** An Ultraviolet Radiation Sensor Using Differential Spectral Response of Silicon Photodiodes. *IEEE SENSORS,* 2015, 1-4